Europäisches Patentamt

European Patent Office

Office européen des brevets

(19)

(11) **EP 0 522 952 B1**

(12) **FASCICULE DE BREVET EUROPEEN**

(45) Date de publication et mention
de la délivrance du brevet:
**05.06.1996 Bulletin 1996/23**

(51) Int Cl.6: **H01L 29/778**, H01L 29/225,
H01L 29/205, H01L 29/36

(21) Numéro de dépôt: **92401940.9**

(22) Date de dépôt: **06.07.1992**

(54) **Transistor à effet de champ, à couches minces de barrière et couche mince dopée**

Feldeffekt-Transistor mit dünnen Barrierenschichten und einer dünnen, dotierten Schicht

Field effect transistor with thin barrier layers and a thin doped layer

(84) Etats contractants désignés:
**DE GB**

(30) Priorité: **08.07.1991 FR 9108544**

(43) Date de publication de la demande:
**13.01.1993 Bulletin 1993/02**

(73) Titulaire: **FRANCE TELECOM**
**F-75015 Paris (FR)**

(72) Inventeurs:
 • **Gérard, Jean-Michel**
  **F-75005 Paris (FR)**
 • **Favre, Jacques**
  **F-78000 Versailles (FR)**

(74) Mandataire: **Dubois-Chabert, Guy et al**
**Société de Protection des Inventions**
**25, rue de Ponthieu**
**F-75008 Paris (FR)**

(56) Documents cités:
**FR-A- 2 646 290**

 • **PATENT ABSTRACTS OF JAPAN vol. 11, no. 351 (E-557)(2798) 17 Novembre 1987**
 • **PATENT ABSTRACTS OF JAPAN vol. 13, no. 155 (E-743)(3503) 14 Avril 1989**
 • **INSTITUTE OF PHYSICS CONFERENCE SERIES, PROCEEDINGS OF THE 15TH. SYMPOSIUM ON GALLIUM ARSENIDE AND RELATED COMPOUNDS HELD IN ATLANTA, GA no. 96, 1988, BRISTOL, GB pages 459 - 464 Y. J. CHAN ET AL. 'Novel p-channel Ga0.51In0.49P/**
 • **InxGa1-xAs/GaAs strained (x=0.1) and lattice-matched (x=0) HEMTs'**
 • **JAPANESE JOURNAL OF APPLIED PHYSICS, PART. 2 vol. 30, no. 2A, Février 1991, TOKYO, JP pages L166 - L169 , XP223143 K. MATSUMURA ET AL. 'A new high electron mobility transistor (HEMT) structure with a narrow quantum well formed by inserting a few monolayers in the channel'**
 • **JP-A-62 130 565(FUJITSU) 12.Juin 1987**

EP 0 522 952 B1

**Description**

La présente invention a pour objet un transistor à effet de champ, à couches minces de bande d'énergie contrôlée, utilisable notamment pour la réalisation de circuits électroniques ou optoélectroniques destinés en particulier aux domaines de la télémétrie, de l'optique intégrée et des télécommunications.

Plus précisément, l'invention se rapporte à des structures semi-conductrices, à un ou plusieurs canaux de conduction et à charges mobiles modulées, telles que les structures de transistors à effet de champ du type TEGFET (transistor à effet de champ et à gaz d'électrons bidimensionnel) et les structures dérivées du TEGFET comme les transistors HEMT (transistor à mobilité élevée d'électrons), MODFET (transistor à effet de champ dopé et à modulation) et DMT (transistor du type MIS (métal-isolant-semi-conducteur) dopé).

Le principe de ces transistors à effet de champ est bien connu.

En particulier, on peut se référer au document IEEE Transactions on Electron Devices, vol. ED-29, n°6 de juin 1982, D. Delagebeaudeuf et N.T. Linh, "Metal-(n) AlGaAs-GaAs two-dimensional electron gaz FET", pp. 955-960 qui décrit le fonctionnement d'un TEGFET ; et au document IEEE Transactions on Electron Devices, vol. 35, n° 7, juillet 1988, M.C. Foisy et al. "The role of inefficient charge modulation in limiting the current-gain cutoff frequency of the MODFET", pp. 871-878 qui décrit le fonctionnement d'un MODFET.

Ce type de structure est réalisé par empilement de couches semi-conductrices de nature différente, dopées ou non dopées, déposées sur un matériau substrat généralement semi-isolant. Le fonctionnement repose sur le principe du transfert de charges électriques (électrons ou trous) à partir de certaines couches dopées, constituant les couches donneuses de charges électriques mobiles, vers d'autres couches dopées ou non dopées qui constituent le ou les canaux de conduction du transistor. Une grille métallique placée en surface de la structure semiconductrice permet de modifier la concentration de porteurs de charges dans chacune de ces couches et de commander les propriétés de conduction du composant. Sur cet empilement de couches semi-conductrices, on trouve aussi deux contacts métalliques de source et de drain, disposés de part et d'autre de la grille.

Dans ce type de structure, l'un des facteurs essentiels à l'amélioration des performances, en hyperfréquence notamment, est la répartition spatiale des porteurs de charges mobiles, électrons ou trous.

Le volume du composant se sépare en deux sous-domaines, d'une part, les canaux de conduction électrique (SD1) et, d'autre part, les autres couches semi-conductrices (SD2), comme les couches donneuses de charges électriques mobiles et les couches tampon généralement interposées entre le substrat et les canaux de conduction.

On définit la concentration de charges mobiles dans un des sous-domaines du composant comme étant, pour une mini-bande donnée, le produit de la concentration de porteurs pour cette mini-bande par la probabilité de présence d'un porteur de cette mini-bande dans le sous-domaine considéré. La concentration totale de charges mobiles dans le sous-domaine SD1 est appelée NS1 ; celle dans le sous-domaine SD2 est appelée NS2.

1°) - La fréquence de coupure.

La fréquence de coupure Fc du gain en courant du composant peut être considérée comme proportionnelle au rapport :

$$Fc = 1 \left/ \left(1 + \frac{dNS2/dVg}{dNS1/dVg}\right) \right. = 1 \left/ \left(1 + \frac{dNS2}{dNS1}\right) \right.$$

où Vg est le potentiel appliqué sur la grille.

Quelle que soit l'application considérée (transistor à faible bruit, de puissance, etc.), pour une fréquence de fonctionnement donnée et donc pour un rapport dNS2/dNS1 maximal fixé, on cherche toujours à disposer de la plus grande plage de valeurs possibles pour NS1, soit 0<NS1<NS1lim où NS1lim est la valeur limite maximale de NS1.

Or, lorsque l'on modifie la tension de grille Vg pour augmenter NS1, le rapport dNS2/dNS1 s'accroît simultanément.

Divers moyens ont été explorés pour améliorer les performances des transistors à effet de champ, via l'accroissement de la discontinuité de bandes (de conduction si le transport est effectué par des électrons, sinon de valence).

Pour améliorer l'efficacité du transfert de charges et réduire le rapport dNS2/dNS1 à NS1 donné, deux solutions ont été envisagées :

a - modifier la ou les couches donneuses de charges mobiles (ou sous-domaine SD2),
b - modifier le matériau dans lequel s'opère la conduction (ou sous-domaine SD1).

a - Les alliages de matériaux III-V ou II-VI dopés, utilisés communément en guise de couches donneuses de charges (SD2) introduisent des pièges à porteurs liés aux atomes dopants, tels que le centre DX dans les alliages III-V qui contiennent de l'aluminium. L'énergie de liaison est alors grande, ce qui limite l'efficacité du transfert de charges des couches SD2 aux couches SD1.

C'est l'existence de ces états localisés (ou porteurs piègés) dans le sous-domaine SD2 qui limite les performances des transistors réalisés sur un substrat en GaAs ou InP tels que ceux décrits dans le document L.D. Nguyen et al., Proc. IEEE/Cornell, Conf. 1987, pp. 60-69 "AlGaAs/InGaAs modulation-doped field effect transistors (MODFET's)".

Sur un substrat en GaAs, ces effets semblent limités pour l'alliage $In_{0,51}Ga_{0,49}P$ adapté du point de vue maille cristalline mais la hauteur de l'hétérojonction est moins élevée que celle accessible dans le système AlGaAs/GaAs.

Dans le cas de structures AlGaAs/GaAs, il a par ailleurs été envisagé la substitution de l'alliage ternaire AlGaAs par un super-réseau d'assez courte période, typiquement inférieure à 5nm. Ce super-réseau consiste en une alternance de couches minces de GaAs et de AlAs. Seules les couches de GaAs sont dopées. Une telle structure est notamment décrite dans le document Proc. IEEE/Cornell Conf., pp.199-208 (1985), de L.H. Camnitz "The role of charge control on drift mobility in AlGaAs/GaAs MODFET's".

Le but du super-réseau est d'obtenir un matériau dont la structure de bande est très voisine de celle de l'alliage ternaire AlGaAs, mais où l'énergie de liaison des impuretés donneuses de charges est faible. Cette technique devait a priori permettre d'augmenter la composition moyenne en aluminium des couches donneuses de charges en supprimant le centre DX et donc d'augmenter l'efficacité du transfert des charges mobiles des couches donneuses de charges vers les couches de conduction.

Cette solution n'a en fait apporté aucune amélioration et n'a donc pas été retenue par les concepteurs et fabricants de transistors à effet de champ.

b - En ce qui concerne la modification du matériau destiné à la conduction, sous-domaine SD1, les alliages de $In_xGa_{1-x}As$ désaccordés en paramètre de maille ont été largement utilisés tant sur un substrat en GaAs, avec $0<x\leq1$, que sur un substrat en InP, avec $0,53<x\leq1$, à la place respectivement de GaAs et d'$In_{0,53}Ga_{0,47}As$.

A ce sujet, on peut se référer à l'article N. Moll et al., IEEE Transactions on Electron Devices, vol. 35, n°7, juillet 1988, pp. 879-886, "Pulse-doped AlGaAs/InGaAs pseudomorphic MODFET's", relatif à l'emploi de $In_{0,25}Ga_{0,75}As$ sur GaAs.

Les alliages de InGaAs présentant une plus petite bande d'énergie interdite que celle de GaAs ou d'$In_{0,53}Ga_{0,47}As$ permettent d'augmenter les discontinuités de bande. Leurs paramètres de maille cristalline sont cependant différents de ceux de GaAs et d'InP et ces couches sont donc contraintes. Ceci limite donc la plage de composition en indium utilisable : typiquement $0<x<0,25$ sur GaAs et $0,53<x<0,65$ sur InP.

Ainsi, la limitation du nombre de matériaux dont le paramètre de maille est suffisamment voisin de celui du matériau nominal ou de base empêche de trouver de nouvelles combinaisons qui réduisent le rapport dNS2/dNS1.

2°) - Les applications à courant élevé.

Le courant de drain disponible dans de tels transistors est typiquement le produit de NS1lim par la vitesse moyenne des porteurs sous la grille. Cette dernière dépend, à forme donnée, essentiellement de la nature des couches semi-conductrices. Les solutions possibles et leurs limites sont celles données dans les paragraphes a et b.

3°) - La linéarité.

Dans ces transistors, on cherche en outre à obtenir une réponse en courant-tension aussi linéaire que possible. Or, la linéarité de réponse d'un transistor est affectée par la modification de la répartition des charges électriques dans la structure entre sous-domaines (SD1 et SD2) et au sein du sous-domaine SD1.

Plus précisément, les densités de probabilité de présence associées à chacune des mini-bandes se déforment avec le changement de la tension appliquée sur la grille, ce qui se traduit par une modification de la position moyenne des électrons par rapport à la grille. Ceci introduit une variation non linéaire en tension de la concentration de porteurs dans les canaux de conduction. L'utilisation de structures AlGaAs/InGaAs/AlGaAs au lieu de AlGaAs/InGaAs/GaAs a déjà permis de limiter cet effet.

A ce sujet, on peut se référer à l'article de C. Gaonach et al., Proc. GaAs and related compounds, Jersey, 1990, "Characterization of pseudomorphic HEMT structures AlGaAs/InGaAs/AlGaAs".

En vue de minimiser le rapport dNS2/dNS1 dans un transistor HEMT on a utilisé par ailleurs une perturbation locale de l'énergie de potentiel de la structure afin de modifier sélectivement les énergies propres et les fonctions d'onde au point considéré des mini-bandes étudiées, susceptibles d'être peuplées de porteurs. En effet, la théorie des perturbations en mécanique quantique montre que l'effet de l'introduction d'une telle pertubation localisée de potentiel provoque un déplacement de l'énergie propre d'autant plus grand que le recouvrement de ce potentiel avec la probabilité de présence dans le système non perturbé est élevé. Une telle perturbation localisée est obtenue par le changement de matériau d'une couche mince de la structure.

Ainsi, il a été envisagé l'introduction d'une monocouche de InAs dans le canal de conduction de structures Al-GaAs/GaAs et AlGaAs/InGaAs réalisant un puits de potentiel ; ceci est décrit dans le document Japanese Journal of Applied Physics, vol. 30, N°2A, février 1991, pp. L166-L169, "A new high electron mobility transistor (HEMT) structure with a narrow quantum well formed by inserting a few monolayers in the channel" de K. Matsumura et al.

L'introduction de ce puits de potentiel en un point donné augmente la probabilité de présence en ce point et augmente son peuplement en réduisant son énergie, d'autant plus que la densité de probabilité de présence est forte en ce point avant la perturbation.

Par ailleurs, il a été envisagé dans le document FR-A-2 646 290 l'introduction d'une couche mince d'AlInAs dopée en bordure du canal de conduction d'une structure en AlGaAs/InGaAs/GaAs afin de créer une barrière tunnel entre l'empilement de conduction et l'empilement donneur, pour éviter le passage des électrons de celui-là vers celui-ci (effet dynamique). En fait, ce concept s'est avéré inopérant.

L'invention a pour objet un transistor à effet de champ, à couches minces de bande d'énergie contrôlée présentant des propriétés améliorées par rapport à ceux actuellement connus. En particulier, l'invention permet d'agir sélectivement sur un niveau quantique par insertion de couches minces dans les canaux de conduction et les couches donneuses de charges mobiles, jouant respectivement le rôle de puits et de barrière de potentiel. Elle permet par rapport aux transistors connus, une amélioration sur les fréquences de fonctionnement, la densité de courant du drain utilisable et la linéarité de réponse de ses composants.

De façon plus précise, l'invention a pour objet un transistor à effet de champ comportant un substrat semi-isolant, au moins un premier empilement de couches semi-conductrices de conduction et au moins un second empilement de couches semi-conductrices, donneur de charges électriques mobiles, superposés et supportés par le substrat, une unique couche mince, d'une épaisseur inférieure à 5 nm, fortement dopée, au sein dudit second empilement, lui conférant son caractère donneur, au moins deux barrières de potentiel situées dans ledit second empilement, respectivement de part et d'autre de la couche mince fortement dopée, afin de diminuer la concentration de porteurs dans ce second empilement, chaque barrière consistant en au moins une monocouche isolante ou semi-conductrice d'un matériau à bande d'énergie interdite supérieure à celles des matériaux des autres couches du second empilement, une grille métallique reposant sur le second empilement pour modifier la concentration de porteurs de charges dans le premier empilement, deux contacts ohmiques disposés sur l'un des empilements, de part et d'autre de la grille, et jouant respectivement le rôle de source et de drain.

Les transistors auxquels s'applique l'invention sont essentiellement les TEGFET et ses dérivés comme les HEMT, MODFET, DMT.

L'introduction de barrières de potentiel en un point donné de la structure semi-conductrice diminue la probabilité de présence en ce point de porteurs mobiles et dépeuple le niveau considéré en élevant son énergie, d'autant plus que la densité de probabilité de présence est forte en ce point avant la perturbation.

L'invention n'est performante que pour un dopage planaire, c'est-à-dire introduit dans un plan atomique, ou dans une couche mince, d'épaisseur inférieure à typiquement 5nm.

L'invention n'est également performante que lorsque le plan de dopage est encadré par deux barrières, de façon à empêcher efficacement les niveaux quantiques d'avoir une forte probabilité de présence au voisinage du plan de dopage.

L'utilisation de deux barrières, de part et d'autre du plan de dopage, fait qu'à l'équilibre thermodynamique le nombre de porteurs est faible dans l'empilement de couches donneur de porteurs libres. Autrement dit, et très grossièrement, les électrons n'ont dans ce cas aucune raison de passer dans cet empilement, ce qui est mieux que de les empêcher de passer (ou d'essayer de les empêcher de passer) alors qu'ils en ont envie.

De façon avantageuse, le transistor comporte, de plus, au moins un puits de potentiel dans ledit premier empilement afin d'augmenter la concentration de porteurs dans ce premier empilement, ce puits consistant en au moins une monocouche semi-conductrice d'un matériau à bande d'énergie interdite inférieure à celles des matériaux des autres couches du premier empilement.

L'introduction d'un puits de potentiel dans les bandes de conduction augmente la probabilité de présence de porteurs dans les bandes de conduction et donc leur peuplement.

En utilisant plusieurs barrières de potentiel dans les couches donneuses de part et d'autre du plan donneur de charges et éventuellement un ou plusieurs puits de potentiel dans les couches de conduction, il est possible d'augmenter la densité de porteurs dans l'empilement des couches de conduction électrique (SD1) et de réduire la densité de porteurs dans l'empilement de couches de conduction (SD2) ; ceci permet de réduire le rapport dNS2/dSN1 à NS1 donné, soit encore d'augmenter NS1 pour une valeur maximale admissible du rapport dNS2/dSN1.

Par ailleurs, les puits de potentiel dans l'empilement de conduction permettent de localiser dans l'espace certains niveaux et en particulier le niveau fondamental ; la densité de probabilité de présence associée à un tel niveau d'énergie est alors ramassée autour de la couche ou des couches qui créent la ou les perturbations attractives. Les barrières de potentiel empêchent la densité de probabilité de présence associée à ces niveaux de glisser vers les couches de conduction (SD2) et permettent qu'elle reste ramassée pour toute la gamme de tensions appliquées sur la grille du transistor.

L'invention s'applique à tout assemblage semi-conducteur utilisant des hétérojonctions permettant d'élever des barrières et de creuser des puits de potentiel. Les matériaux semi-conducteurs à grande largeur de bande interdite formeront le plus souvent les barrières de potentiel et les matériaux à faible largeur de bande interdite formeront en principe les puits de potentiel.

En particulier, l'invention s'applique à toute structure semi-conductrice III-V, II-VI et IV-VI. Plus spécialement, l'invention s'applique à des structures sur substrat de GaAs ou InP.

Lorsque le substrat est en GaAs, les couches du premier empilement autres que le ou les puits de potentiel sont en $In_xGa_{1-x}As$ avec $0 \leq x < 1$, le ou les puits de potentiel sont en $In_{xo}Ga_{1-xo}As$ avec $x < xo \leq 1$, les couches du second empilement autres que les barrières de potentiel sont en $Al_yGa_{1-y}As$ avec $0 < y \leq 1$ et les barrières de potentiel sont en $Al_{yo}Ga_{1-yo}As$ avec $y < yo \leq 1$.

De préférence, pour un substrat en GaAs, les puits de potentiel sont en InAs et les barrières de potentiel en AlAs. En outre, on utilise en pratique, comme empilement de couches, donneur de charges mobiles du AlGaAs avec $0,20 < y < 1$.

Il est en outre possible, pour un substrat en GaAs de remplacer les couches donneuses en AlGaAs par des couches en $In_zGa_{1-z}P$ avec $0 < z \leq 0,7$ et les barrières de potentiel en AlAs par des monocouches d'$In_{zo}Ga_{1-zo}P$ avec $0 < zo < z$.

Lorsque le substrat est en InP, les couches du premier empilement autres que le ou les puits de potentiel sont en $In_tGa_{1-t}As$ avec $0,3 \leq t \leq 1$, le ou les puits de potentiel sont en $In_{to}Ga_{1-to}As$ avec $t < to \leq 1$, les couches du second empilement autres que les barrières de potentiel sont en $Al_uIn_{1-u}As$ avec $0,3 \leq u \leq 1$ et les barrières de potentiel sont en $Al_{uo}In_{1-uo}As$ avec $u \leq uo \leq 1$.

De préférence, pour un substrat en InP, on utilise des puits de potentiel en InAs et des barrières de potentiel en AlAs.

Sur des substrats en CdTe, on utilise des couches de conduction et des couches donneuses de charges en $Hg_{1-v}Cd_vTe$ avec $0 \leq v \leq 1$, les couches barrières étant obtenues pour des compositions vo en Cd telles que $vo > v$ et les puits de potentiel étant obtenus pour des compositions en Cd telles que $vo < v$, avec v et vo supérieurs à 0,15, valeur en-deçà de laquelle le matériau devient semi-métallique.

Le nombre de barrières et de puits de potentiel sont déterminés de façon à optimiser les performances électriques du composant. Par ailleurs, les barrières et les puits de potentiel peuvent consister chacun en une ou plusieurs monocouches de matériau.

Le nombre de monocouches par barrière et puits est limité en pratique par l'état de l'art de la croissance de ces couches. En effet, actuellement, les couches très désadaptées du point de vue de leur maille cristalline (désaccord de maille >2%) ne peuvent pas être accumulées au-delà d'une certaine limite au-delà de laquelle la couche déposée adopte un mode de croissance tridimensionnel, incompatible avec l'obtention d'une hétérostructure de bonne qualité.

Ainsi, cette limite est à l'heure actuelle de deux monocouches pour InAs sur GaAs. Dans le cas d'InAs sur $In_{0,3}Ga_{0,7}As$, elle est très inférieure à une monocouche, ce qui rend dans la pratique peu intéressante l'utilisation de puits d'InAs dans des structures GaAs/Ga$_{0,7}$In$_{0,3}$As/GaAlAs.

Enfin, une telle limite n'intervient pas lorsque la couche insérée est quasiment accordée au paramètre de maille du substrat. C'est le cas pour une couche d'AlAs sur un substrat de GaAs. Les barrières d'AlAs sont donc très commodes d'emploi pour des structures TEGFET GaAs/GaAlAs ou GaAs/GaInAs/GaAlAs.

Selon l'invention, une monocouche pour un matériau binaire III-V (respectivement II-VI) correspond à une couche d'atomes de l'élément III (respectivement II) plus une couche d'atomes de l'élément V (respectivement VI). De même, une monocouche d'un matériau ternaire III-V (respectivement II-VI) correspond à l'empilement de trois couches d'atomes, une couche d'atomes par élément du matériau ternaire.

A titre d'exemple, pour un substrat en GaAs, avec des couches donneuses en AlGaAs et des couches de conduction en InGaAs, on peut utiliser de deux à cinq barrières de potentiel en AlAs de deux monocouches chacune et un puits de potentiel constitué d'une monocouche d'InAs.

Pour un substrat en GaAs, avec des couches donneuses de charges en AlGaAs et des couches de conduction en GaAs, on peut utiliser de deux à cinq barrières d'AlAs de deux monocouches chacune et deux puits de potentiel d'InAs de deux monocouches chacun.

Pour un substrat en InP, avec des couches donneuses en AlInAs et des couches de conduction en InGaAs, il est possible d'utiliser de deux à cinq barrières d'AlAs de deux à quatre monocouches chacune et un à cinq puits de potentiel en InAs constitués chacun de deux à quatre monocouches.

D'autres caractéristiques et avantages de l'invention ressortiront mieux de la description qui va suivre, donnés à titre illustratif et non limitatif, en référence aux dessins annexés, dans lesquels :

- la figure 1 représente schématiquement un transistor à effet de champ monocanal conforme à l'invention,

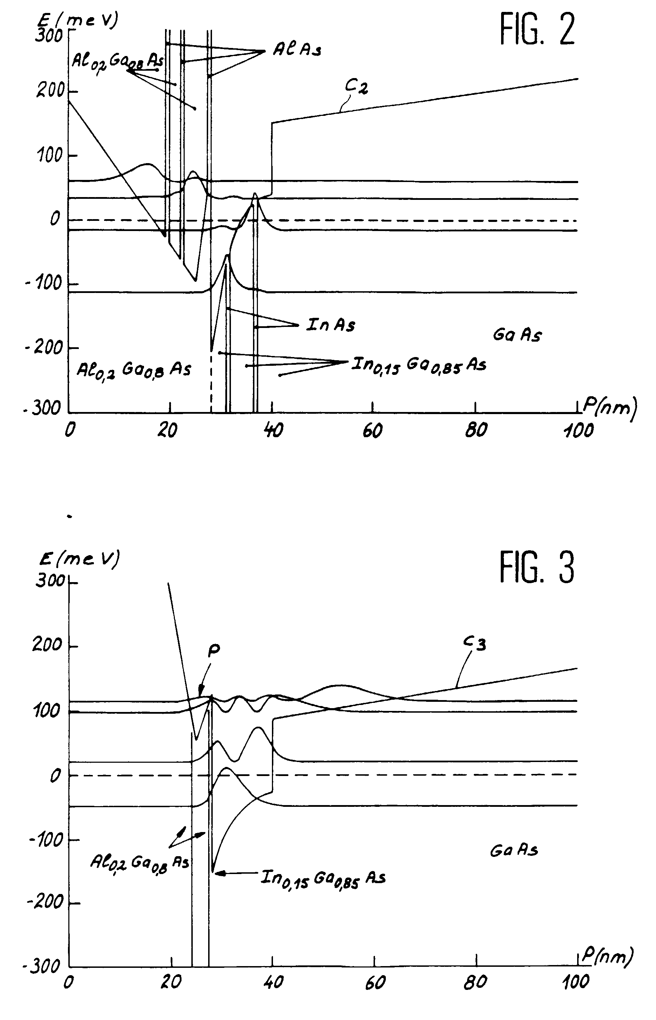

- les figures 2, 3 et 4 sont des profils de bas de bande de conduction, respectivement d'un transistor de l'invention à deux puits et trois barrières de potentiel, d'un transistor de l'art antérieur sans perturbation et d'un transistor de l'invention à trois barrières de potentiel, lorsque la concentration totale de charges mobiles NS2 dans les couches donneuses de charges mobiles et les couches tampon (SD2) est d'environ 10% de la concentration d'électrons présente dans le canal de conduction ; ces figures donnent les variations de l'énergie de bande (E), exprimée en meV, en fonction de la position (p) exprimée en nm dans la structure semi-conductrice, la position 0 correspondant à la surface des couches semi-conductrices actives au contact de la grille,

-   la figure 5 représente les évolutions de la concentration électronique bidimensionnelle en conduction parallèle, soit NS2, en fonction de la concentration électronique dans le canal de conduction, soit NS1, pour respectivement les structures de bande des figures 2, 3 et 4.

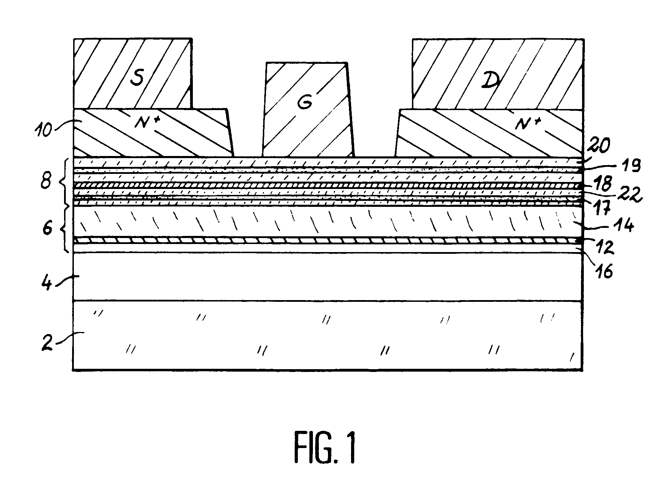

Sur la figure 1, on a représenté schématiquement un transistor à effet de champ monocanal du type TEGFET conforme à l'invention. Ce transistor comporte un substrat 2 semi-isolant monocristallin en matériau III-V supportant une couche tampon 4 non intentionnellement dopée, de même composition que le substrat 2 destinée à éloigner les couches actives semi-conductrices du substrat.

Ces couches actives se composent d'un premier empilement 6 de couches semi-conductrices non intentionnellement dopées, en matériau III-V constituant le canal de conduction du transistor puis d'un second empilement 8 de couches semi-conductrices, dopé n+ et donneur de charges mobiles. Le canal de conduction 6 est ici pris en sandwich entre la couche tampon 4 et l'empilement 8 donneur de charges mobiles.

A la surface supérieure de ces couches actives, on trouve une grille métallique de commande G et deux contacts ohmiques respectivement S et D disposés sur les couches actives et de part et d'autre de la grille G jouant respectivement le rôle de source et de drain. La prise de contact électrique respectivement de la source et du drain sur les couches actives est assurée par une couche active 10 en matériau III-V dopée n+, gravée de façon à isoler électriquement la grille du transistor de la source et du drain.

Selon l'invention, le caractère donneur de l'empilement 8 est assuré par une couche mince 18 fortement dopée d'épaisseur inférieure à 5nm. En outre, au moins un puits de potentiel 12 est prévu dans l'empilement de conduction 6 alors que deux barrières de potentiel au moins, respectivement 17 et 19, sont prévues dans l'empilement donneur 8 de charges mobiles. Par ailleurs, ces barrières 17 et 19 sont situées de part et d'autre de la couche mince fortement dopée 18.

Le puits de potentiel 12 est constitué de quelques monocouches d'un matériau III-V non intentionnellement dopé dont la bande d'énergie interdite est inférieure à celle des autres couches semi-conductrices 14 et 16 de l'empilement de conduction 6.

Parallèlement, les barrières de potentiel 17,19 sont constituées de quelques monocouches d'un matériau III-V non intentionnellement dopé dont la bande d'énergie interdite est supérieure à celles des autres couches semi-conductrices 20 et 22 de l'empilement 8 donneur de charges mobiles.

A titre d'exemple, pour un substrat 2 en GaAs, on utilise des couches de conduction 14 et 16 en $In_xGa_{1-x}As$ avec $0 \leq x < 1$ non intentionnellement dopé, de 2 à 20nm d'épaisseur, 1 ou plusieurs puits de potentiel 12 en InAs non intentionnellement dopé de 0,6nm d'épaisseur (soit 2 monocouches), des couches 20 et 22 donneuses de charges mobiles en $Al_yGa_{1-y}As$ avec $0,20 < y < 1$ de 2 à 20nm d'épaisseur avec une couche 18 de dopage n+, deux ou plus de couches barrières 17, 19 en AlAs de 0,6nm d'épaisseur chacune (soit 2 monocouches), une couche tampon 4 en GaAs non intentionnellement dopé de 1 μm d'épaisseur et une couche 10 de contact électrique en GaAs dopé N+, gravée, de 100nm d'épaisseur.

Le dopage de l'empilement 8 donneur de charges mobiles est obtenu en interrompant la croissance d'AlGaAs, en déposant 1 à $10.10^{12}$ atomes/cm$^2$ de Si puis en reprenant la croissance d'AlGaAs. On obtient ainsi un dopage dit "planaire".

Dans la couche de contact 10, on utilise de $10^{18}$ à $10^{19}$ atomes/cm$^3$ de silicium.

On donne ci-après différents exemples de réalisation de transistors à effet de champ conformes à l'invention et un contre-exemple.

Dans ces exemples et contre-exemple, les couches seront données dans l'ordre en partant de la couche semi-conductrice dopée N+ de contact électrique jusqu'au substrat.

EXEMPLE 1

Cet exemple est relatif à un TEGFET du type n-$Al_{0,22}Ga_{0,78}As$/$In_{0,15}Ga_{0,85}As$/GaAs monocanal de conduction avec un dopage planaire de $5.10^{12}$ atomes donneurs d'électrons, ionisés par cm$^2$. Ce TEGFET comporte trois barrières de potentiel en AlAs de deux monocouches chacune et deux puits de potentiel en InAs contraints de deux monocouches chacun.

|  | COUCHE | DOPAGE | EPAISSEUR |
|---|---|---|---|
| CONTACT | GaAs N+ | $2.10^{18}$/cm$^3$ | 100 nm |

(suite)

|  | COUCHE | DOPAGE | EPAISSEUR |
|---|---|---|---|
| EMPILEMENT DONNEUR | $Al_{0,22}Ga_{0,78}As$ | nid | 19 nm |
|  | AlAs | nid | 0,6 nm |
|  | $Al_{0,22}Ga_{0,78}As$ | nid | 2,4 nm |
|  | AlAs | nid | 0,6 nm |
|  | $Al_{0,22}Ga_{0,78}As$ | nid | 2,4 nm |
|  | plan de dopage | $5.10^{12}$ at.Si/cm$^2$ | - |
|  | $Al_{0,22}Ga_{0,78}As$ | nid | 2,4 nm |
|  | AlAs | nid | 0,6 nm |
| EMPILEMENT DE CONDUCTION | $In_{0,15}Ga_{0,85}As$ | nid | 3 nm |
|  | InAs | nid | 0,6 nm |
|  | $In_{0,15}Ga_{0,85}As$ | nid | 4,8 nm |
|  | InAs | nid | 0,6 nm |
|  | $In_{0,15}Ga_{0,85}As$ | nid | 3 nm |
| TAMPON | GaAs | nid | 1 µm |
| SUBSTRAT | GaAs | semi-isolant | - |

nid signifie que la couche est non intentionnellement dopée.

CONTRE-EXEMPLE

Le contre-exemple est relatif à un TEGFET du type n-$Al_{0,22}Ga_{0,78}As$/$In_{0,15}Ga_{0,85}As$/GaAs monocanal de conduction et un dopage planaire de $5.10^{12}$ atomes donneurs d'électrons ionisés par cm$^2$. Le TEGFET est non perturbé et relatif à l'art antérieur.

|  | COUCHE | DOPAGE | EPAISSEUR |
|---|---|---|---|
| CONTACT | GaAs N+ | $2.10^{18}$/cm$^3$ | 100 nm |
| EMPILEMENT DONNEUR | $Al_{0,22}Ga_{0,78}As$ | nid | 29 nm |
|  | plan de dopage | $5.10^{12}$ at.Si/cm$^2$ | - |
|  | $Al_{0,22}Ga_{0,78}As$ | nid | 3 nm |
| CANAL DE CONDUCTION | $In_{0,15}Ga_{0,85}As$ | nid | 12 nm |
| TAMPON | GaAs | nid | 1 µm |
| SUBSTRAT | GaAs | semi-isolant | - |

EXEMPLE 2

Cet exemple est relatif à un TEGFET du type n-$Al_{0,22}Ga_{0,78}As$/GaAs monocanal de conduction, avec un dopage planaire de $5.10^{12}$ atomes donneurs d'électrons ionisés par cm$^2$. Ce TEGFET comporte trois barrières de potentiel en AlAs de deux monocouches chacune.

|  | COUCHE | DOPAGE | EPAISSEUR |
|---|---|---|---|
| CONTACT | GaAs N+ | $2.10^{18}$/cm$^3$ | 100 nm |

(suite)

|  | COUCHE | DOPAGE | EPAISSEUR |
|---|---|---|---|
| EMPILEMENT DONNEUR | $Al_{0,22}Ga_{0,78}As$ | nid | 19 nm |
|  | AlAs | nid | 0,6 nm |
|  | $Al_{0,22}Ga_{0,78}As$ | nid | 2,4 nm |
|  | AlAs | nid | 0,6 nm |
|  | $Al_{0,22}Ga_{0,78}As$ | nid | 2,4 nm |
|  | plan de dopage | $5.10^{12}$ at.Si/cm$^2$ | - |
|  | $Al_{0,22}Ga_{0,78}As$ | nid | 2,4 nm |
|  | AlAs | nid | 0,6 nm |
| EMPILEMENT DE CONDUCTION | $In_{0,15}Ga_{0,85}As$ | nid | 12 nm |
| TAMPON | GaAs | nid | 1 µm |
| SUBSTRAT | GaAs | semi-isolant | - |

Sur les figures 2, 3 et 4, on a représenté respectivement les profils de bas de bande de conduction du TEGFET selon l'invention de l'exemple 1, du TEGFET selon l'art antérieur du contre-exemple et du TEGFET selon l'invention de l'exemple 2, lorsque la concentration d'électrons NS2 dans les couches donneuses et la couche tampon (sous-domaine SD2) est d'environ 10% de la concentration bidimensionnelle d'électrons NS1 présente dans le canal de conduction. En fait, ces figures donnent les variations de l'énergie de bande E, en meV, en fonction de la position p, en nm, dans la structure semi-conductrice. La valeur p=0 correspond à la surface supérieure de l'empilement donneur 8 (surface au contact de la grille G).

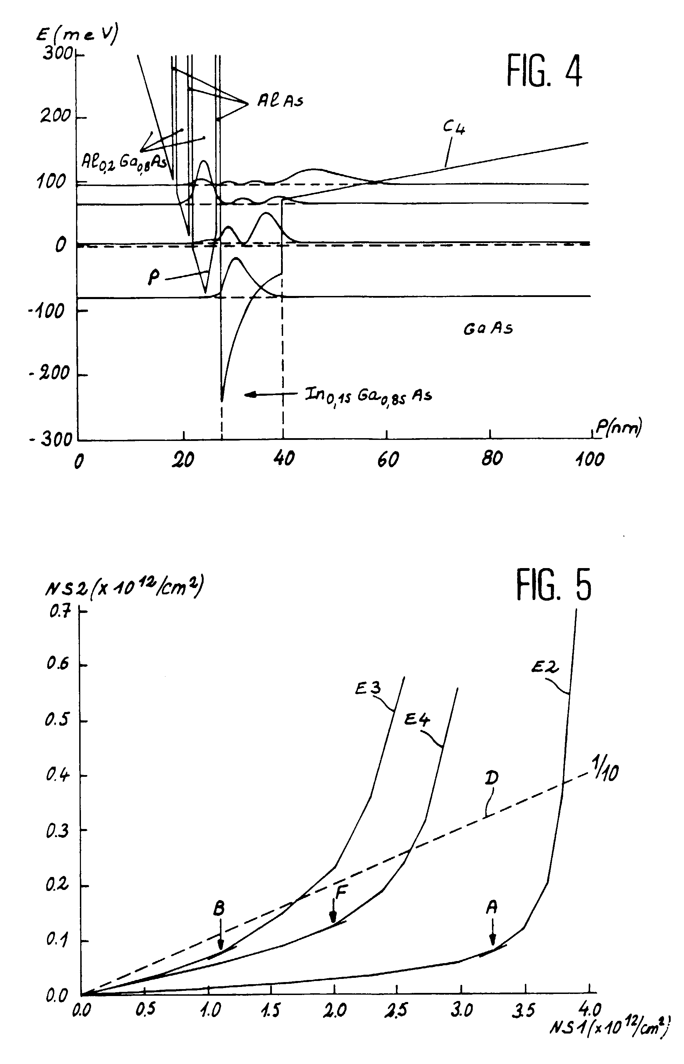

Sur ces figures 2, 3 et 4, on a mentionné la nature des couches semi-conductrices des transistors. P sur les figures 3 et 4 indique le plan ou couche de dopage des couches donneuses. C2, C3 et C4 représentent respectivement les profils de bandes de conduction du transistor perturbé de l'exemple 1, du transistor du contre-exemple non perturbé et du transistor perturbé de l'exemple 2.

En comparant les figures 2, 3 et 4, on constate que les puits de potentiel en InAs ont pour effet d'abaisser l'énergie des deux mini-bandes présentes dans l'empilement de conduction en $In_{0,15}Ga_{0,85}As$ et que les barrières en AlAs permettent d'interdire partiellement la conduction parallèle et de remonter ainsi le niveau d'énergie des mini-bandes considérées.

Les courbes E2, E3 et E4 de la figure 5 représentent les évolutions respectives de la concentration électronique bidimensionnelle en conduction parallèle, soit NS2, en fonction de la concentration NS1 d'électrons dans l'empilement de conduction 6 pour respectivement les structures de l'exemple 1, du contre-exemple et de l'exemple 2.

Sur la figure 5, on a fait apparaître en A, B et C les pentes 1/10 des courbes respectivement E2, E3 et E4 et on a tracé la droite D correspondant à NS2/NS1=10%.

On constate que la structure perturbée de l'exemple 1 (courbe E2) récupère 2,2 fois plus d'électrons utiles que la structure non perturbée (courbe E3) pour une même conduction parallèle NS2/NS1=10%. En effet, pour NS2/NS1=10%, on obtient $1,7.10^{12}$ électrons/cm$^2$ dans l'empilement de conduction de la structure non perturbée contre $3,7.10^{12}$ électrons/cm$^2$ dans l'empilement de conduction de la structure perturbée de l'invention.

Pour des valeurs voisines de la commande de charges dNS2/dNS1=0,1 (pente en A et B des courbes E2 et E3), NS1 est augmenté d'un facteur voisin de 3 lorsque l'on passe de la structure non perturbée (courbe E3) à la structure de l'invention (courbe E2).

Lorsque l'on compare les courbes E3 et E4, on constate que la structure perturbée de l'exemple 2 récupère plus d'électrons utiles que la structure non perturbée pour une même conduction parallèle NS2/NS1=10%, $1,7.10^{12}$ contre $2,6.10^{12}$ électrons/cm$^2$. Pour des valeurs voisines de la commande de charges dNS2/dNS1=0,1 (pente F et B), NS1 est augmenté d'un facteur 2 environ.

EXEMPLE 3

Cet exemple est relatif à un transistor HEMT du type n-$Al_{0,48}In_{0,52}As/In_{0,53}Ga_{0,47}As/InP$ monocanal de conduction avec un dopage plan de $6.10^{12}$ atomes donneurs d'électrons par cm$^2$. Dans cet exemple, les alliages InGaAs et InAlAs sont quasiment adaptés au substrat d'InP.

Ce transistor comporte trois barrières de potentiel en AlAs dans l'empilement donneur et deux puits de potentiel en InAs dans l'empilement de conduction. En outre, ce transistor comporte une couche barrière de potentiel en $Al_{0,48}In_{0,52}As$ entre la couche tampon et l'empilement de conduction, non donneuse d'électrons de façon à empêcher que les électrons sortent du canal de conduction.

|  | COUCHE | DOPAGE | EPAISSEUR |
|---|---|---|---|
| CONTACT | $In_{0,53}Ga_{0,47}As$ | $2.10^{18}/cm^3$ | 5 nm |
| EMPILEMENT DONNEUR | $Al_{0,48}In_{0,52}As$ | nid | 20 nm |
|  | AlAs | nid | 0,6 nm |
|  | $Al_{0,48}In_{0,52}As$ | nid | 2,4 nm |
|  | AlAs | nid | 0,6 nm |
|  | $Al_{0,48}In_{0,52}As$ | nid | 2,4 nm |
|  | plan de dopage | $6.10^{12}$ at.Si/$cm^2$ | - |
|  | $Al_{0,48}In_{0,52}As$ | nid | 2,4 nm |
|  | AlAs | nid | 0,6 nm |
| EMPILEMENT DE CONDUCTION | $In_{0,53}Ga_{0,47}As$ | nid | 5 nm |
|  | InAs | nid | 0,6 nm |
|  | $In_{0,53}Ga_{0,47}As$ | nid | 10 nm |
|  | InAs | nid | 0,6 nm |
|  | $In_{0,53}Ga_{0,47}As$ | nid | 5 nm |
| BARRIERE | $Al_{0,48}In_{0,52}As$ | nid | 20 nm |
| TAMPON | InP | nid | 1 μm |
| SUBSTRAT | InP | semi-isolant | - |

EXEMPLE 4

Cet exemple est relatif à un transistor HEMT à deux canaux de conduction du type n-$Al_{0,22}Ga_{0,78}As/In_{0,15}Ga_{0,85}As/GaAs$ avec deux plans de dopage de respectivement $5.10^{12}$ et $1,5.10^{12}$ at/$cm^2$ donneurs d'électrons. Ce transistor comporte trois barrières de potentiel en AlAs dans les deux empilements donneurs de charges mobiles et deux puits de potentiel en InAs dans l'empilement de conduction situé entre les deux empilements donneurs de charges.

|  | COUCHE | DOPAGE | EPAISSEUR |
|---|---|---|---|
| CONTACT | GaAs N+ | $2.10^{18}/cm^3$ | 100 nm |
| EMPILEMENT DONNEUR | $Al_{0,22}Ga_{0,78}As$ | nid | 19 nm |
|  | AlAs | nid | 0,6 nm |
|  | $Al_{0,22}Ga_{0,78}As$ | nid | 2,4 nm |
|  | AlAs | nid | 0,6 nm |
|  | $Al_{0,22}Ga_{0,78}As$ | nid | 2,4 nm |
|  | plan de dopage | $5.10^{12}$ at.Si/$cm^2$ | - |
|  | $Al_{0,22}Ga_{0,78}As$ | nid | 2,4 nm |
|  | AlAs | nid | 0,6 nm |

(suite)

|  | COUCHE | DOPAGE | EPAISSEUR |
|---|---|---|---|
| EMPILEMENT DE CONDUCTION | $In_{0,15}Ga_{0,85}As$ | nid | 3 nm |
|  | InAs | nid | 0,6 nm |
|  | $In_{0,15}Ga_{0,85}As$ | nid | 4,8 nm |
|  | InAs | nid | 0,6 nm |
|  | $In_{0,15}Ga_{0,85}As$ | nid | 3 nm |
| EMPILEMENT DONNEUR | AlAs | nid | 0,6 nm |
|  | $Al_{0,22}Ga_{0,78}As$ | nid | 4,5 nm |
|  | plan de dopage | $1,5.10^{12}$ at.Si/cm$^2$ | - |
|  | $Al_{0,22}Ga_{0,78}As$ | nid | 2,4 nm |
|  | AlAs | nid | 0,6 nm |
|  | $Al_{0,22}Ga_{0,78}As$ | nid | 6 nm |
|  | AlAs | nid | 0,6 nm |
| TAMPON | GaAs | nid | 1 µm |
| SUBSTRAT | GaAs | semi-isolant | - |

**Revendications**

1. Transistor à effet de champ comportant un substrat semi-isolant, au moins un premier empilement (6) de couches semi-conductrices de conduction et au moins un second empilement (8) de couches semi-conductrices, donneur de charges électriques mobiles, superposés et supportés par le substrat (2), une unique couche mince (18), d'une épaisseur inférieure à 5 nm, fortement dopée, au sein dudit second empilement, lui conférant son caractère donneur, au moins deux barrières de potentiel (17, 19) situées dans ledit second empilement, respectivement de part et d'autre de la couche mince fortement dopée, afin de diminuer la concentration de porteurs dans ce second empilement, chaque barrière (17, 19) consistant en au moins une monocouche semi-conductrice d'un matériau à bande d'énergie interdite supérieure à celles des matériaux des autres couches (20, 22) du second empilement, une grille métallique (G) reposant sur le second empilement pour modifier la concentration des porteurs de charges dans le premier empilement, deux contacts ohmiques (S, D) disposés sur l'un des empilements, de part et d'autre de la grille, et jouant respectivement le rôle de source et de drain.

2. Transistor selon la revendication 1, caractérisé en ce qu'il comprend, de plus, au moins un puits de potentiel (12) dans ledit premier empilement afin d'augmenter la concentration de porteurs dans ce premier empilement, ce puits (12) consistant en au moins une monocouche semi-conductrice d'un matériau à bande d'énergie interdite inférieure à celles des matériaux des autres couches (14, 16) du premier empilement.

3. Transistor selon la revendication 1 ou 2, caractérisé en ce que le substrat (2), les couches du premier empilement (6) et les couches du second empilement (8) sont réalisés en un matériau III-V.

4. Transistor selon la revendication 2, caractérisé en ce que le substrat (2) est en GaAs, les couches (14, 16) du premier empilement (6) autres que le puits de potentiel (12) sont en $In_xGa_{1-x}As$ avec $0 \leq x < 1$, le puits de potentiel (12) est en $In_{xo}Ga_{1-xo}As$ avec $x < xo \leq 1$, les couches (20, 22) du second empilement autres que les barrières de potentiel sont en $Al_yGa_{1-y}As$ avec $0 < y \leq 1$ et les barrières de potentiel (17, 19) sont en $Al_{yo}Ga_{1-yo}As$ avec $y < yo \leq 1$.

5. Transistor selon la revendication 4, caractérisé en ce que le puits de potentiel (12) est en InAs, les couches (20, 22) du second empilement autres que les barrières de potentiel sont en $Al_yGa_{1-y}As$ avec $0,20 < y < 1$ et les barrières de potentiel (17, 19) sont en AlAs.

6. Transistor selon la revendication 2, caractérisé en ce que le substrat est en GaAs, les couches (14, 16) du premier empilement (6) autres que le puits de potentiel (12) sont en $In_xGa_{1-x}As$ avec $0 \le x < 1$, le puits de potentiel (12) est en $In_{xo}Ga_{1-xo}As$ avec $x < xo \le 1$, les couches (20, 22) du second empilement autres que les barrières de potentiel sont en $In_zGa_{1-z}P$ avec $0 < z \le 0,7$ et les barrières de potentiel (17, 19) sont en $In_{zo}Ga_{1-zo}P$ avec $0 < zo \le z$.

7.   Transistor selon la revendication 6, caractérisé en ce que le puits de potentiel est en InAs et les barrières de potentiel sont en GaP.

8.   Transistor selon la revendication 2, caractérisé en ce que le substrat (2) est en InP, les couches (14, 16) du premier empilement autres que le puits de potentiel (12) sont en $In_tGa_{1-t}As$ avec $0,3 \le t \le 1$, le puits de potentiel (12) est en $In_{to}Ga_{1-to}As$ avec $t < to \le 1$, les couches (20, 22) du second empilement autres que les barrières de potentiel (18) sont en $Al_uIn_{1-u}As$ avec $0,3 \le u \le 1$ et les barrières de potentiel (17, 19) sont en $Al_{uo}In_{1-uo}As$ avec $u < uo \le 1$.

9.   Transistor selon la revendication 8, caractérisé en ce que le puits de potentiel est en InAs et les barrières de potentiel sont en AlAs.

10.  Transistor selon l'une quelconque des revendications 1 à 9, caractérisé en ce qu'une couche tampon (4) semi-conductrice non intentionnellement dopée est prévue entre le substrat (2) et le premier empilement (6) de couches, cette couche tampon étant de même nature que le substrat.

11.  Transistor selon l'une quelconque des revendications 1 à 10, caractérisé en ce qu'un matériau (10) semi-conducteur fortement dopé est interposé entre le second empilement (8) de couches et respectivement la source et le drain (S, G), ce matériau étant de même nature que le substrat (2).

12.  Transistor selon l'une quelconque des revendications 1 à 11, caractérisé en ce qu'il consiste en un transistor du type TEGFET ou en un dérivé de ce type de transistor.


**Patentansprüche**

1.   Feldeffektransistor mit einem halbisolierenden Substrat, mindestens einer ersten Schichtanordnung (6) aus Leitungs-Halbleiterschichten und mindestens einer zweiten Schichtanordnung (8) aus Halbleiterschichten als Donator für elektrische bewegliche Ladungen, welche übereinander liegen und von dem Substrat (2) getragen werden, mit einer einmaligen dünnen Schicht (18), deren Stärke unterhalb von 5 nm liegt, die stark dotiert ist und im Inneren der zweiten Schichtanordnung liegt, um dieser ihre Donator-Eigenschaft zu verleihen, mit mindestens zwei Potentialbarrieren (17, 19), die in der zweiten Schichtanordnung auf der einen bzw. der anderen Seite der stark dotierten dünnen Schicht liegen, um die Trägerkonzentration in der zweiten Schichtanordnung zu verringern, wobei jede Barriere (17, 19) aus mindestens einer halbleitenden Einzelschicht aus einem Material besteht, dessen verbotenes Energieband oberhalb von denjenigen der Materialien der anderen Schichten (20, 22) der zweiten Schichtanordnung liegt, mit einem metallischen Gate (G), welches auf der zweiten Schichtanordnung liegt, um die Konzentration von Ladungsträgern in der ersten Schichtanordnung zu modifizieren, und mit zwei Ohmschen Kontakten (S, D), die auf einer der Schichtanordnungen auf der einen und der anderen Seite des Gates angeordnet sind und die Rolle von Source bzw. Drain spielen.

2.   Transistor nach Anspruch 1,
     **dadurch gekennzeichnet,**
     daß er weiterhin mindestens einen Potentialtopf (12) in der ersten Schichtanordnung aufweist, um die Trägerkonzentration in dieser ersten Schichtanordnung zu erhöhen, wobei dieser Topf (12) aus mindestens einer halbleitenden Einzelschicht eines Materials besteht, dessen verbotenes Energieband unterhalb derjenigen der Materialien der übrigen Schichten (14, 16) der ersten Schichtanordnung liegt.

3.   Transistor nach Anspruch 1 oder 2,
     **dadurch gekennzeichnet,**
     daß das Substrat (2), die Schichten der ersten Schichtanordnung (6) und die Schichten der zweiten Schichtanordnung (8) aus einem III-V-Material gebildet sind.

4.   Transistor nach Anspruch 2,
     **dadurch gekennzeichnet,**
     daß das Substrat (2) aus GaAs besteht, daß die Schichten (14, 16) der ersten Schichtanordnung (6) mit Ausnahme des Potentialtopfs (12) aus $In_xGa_{1-x}As$ mit $0 \leq x < 1$ besteht, daß der Potentialtopf (12) aus $In_{xo}Ga_{1-xo}As$ mit $x < xo \leq 1$ besteht, die Schichten (20, 22) der zweiten Schichtanordnung mit Ausnahme der Potentialbarriere aus $Al_yGa_{1-y}As$ mit $0 < y \leq 1$ bestehen und die Potentialbarrieren (17, 19) aus $Al_{yo}Ga_{1-yo}As$ mit $y < yo \leq 1$ bestehen.

5.  Transistor nach Anspruch 4,
    **dadurch gekennzeichnet,**
    daß der Potentialkopf (12) aus InAs besteht, die Schichten (20, 22) der zweiten Schichtanordnung mit Ausnahme der Potentialbarrieren aus $Al_yGa_{1-y}As$ mit $0,20 < y < 1$ bestehen und die Potentialbarrieren (17, 19) aus AlAs bestehen.

6.  Transistor nach Anspruch 2,
    **dadurch gekennzeichnet,**
    daß das Substrat aus GaAs besteht, die Schichten (14, 16) der ersten Schichtanordnung (6) mit Ausnahme des Potentialtopfs (12) aus $In_xGa_{1-x}As$ mit $0 \leq x < 1$ bestehen, der Potentialtopf (12) aus $In_{xo}Ga_{1-xo}As$ mit $x < xo \leq 1$ besteht, die Schichten (20, 22) der zweiten Schichtanordnung mit Ausnahme der Potentialbarrieren aus $In_zGa_{1-z}P$ mit $0 < z \leq 0,7$ bestehen, und die Potentialbarrieren (17, 19) aus $In_{zo}Ga_{1-zo}P$ mit $0 < zo \leq z$ bestehen.

7.  Transistor nach Anspruch 6,
    **dadurch gekennzeichnet,**
    daß der Potentialtopf aus InAs und die Potentialbarrieren aus GaP bestehen.

8.  Transistor nach Anspruch 2,
    **dadurch gekennzeichnet,**
    daß das Substrat (2) aus InP besteht, die Schichten (14, 16) der ersten Schichtanordnung mit Ausnahme des Potentialtopfs (12) aus $In_tGa_{1-t}As$ mit $0,3 \leq t \leq 1$ bestehen, der Potentialtopf (12) aus $In_{to}Ga_{1-to}As$ mit $t < to \leq 1$ besteht, die Schichten (20, 22) der zweiten Schichtanordnung mit Ausnahme der Potentialbarrieren (18) aus $Al_uIn_{1-u}As$ mit $0,3 < u < 1$ bestehen und die Potentialbarrieren (17, 19) aus $Al_{uo}In_{1-uo}As$ mit $u < uo \leq 1$ bestehen.

9.  Transistor nach Anspruch 8,
    **dadurch gekennzeichnet,**
    daß der Potentialtopf aus InAs und die Potentialbarrieren aus AlAs bestehen.

10. Transistor nach einem der Ansprüche 1 bis 9,
    **dadurch gekennzeichnet,**
    daß eine halbleitende Pufferschicht (4) ohne beabsichtigte Dotierung zwischen dem Substrat (2) und der ersten Schichtanordnung (6) vorgesehen ist, wobei diese Pufferschicht die gleiche Beschaffenheit wie das Substrat besitzt.

11. Transistor nach einem der Ansprüche 1 bis 10,
    **dadurch gekennzeichnet,**
    daß zwischen der zweiten Schichtanordnung (8) und jeweils der Source und dem Drain (S, G) ein stark dotiertes Halbleitermaterial (10) liegt, wobei dieses Material die gleiche Beschaffenheit wie das Substrat (2) aufweist.

12. Transistor nach einem der Ansprüche 1 bis 11,
    **dadurch gekennzeichnet,**
    daß es sich um einen Transistor vom Typ TEGFET oder einen von diesem Transistortyp abgeleiteten Transistor handelt.

## Claims

1.  Field effect transistor having a semiinsulating substrate, at least one first stack (6) of semiconductor conduction layers and at least one second stack (8) of semiconductor, mobile electric charge donor layers, which are superimposed and supported by the substrate (2), a single highly doped thin film (18) with a thickness below 5 nm within said second stack giving it its donor character, at least two potential barriers (17,19) located in said second stack, respectively on either side of the highly doped thin film in order to reduce the concentration of carriers in said second stack, each barrier (17, 19) consisting of at least one insulating or semiconductor monolayer of a material having a forbidden energy band greater than those of the materials of the other layers (20,22) of the second stack, a metal gate (G) resting on the second stack to modify the concentration of charge carriers in the first stack, two ohmic contacts (S,D) being placed on one of the stacks, on either side of the gate, and serving respectively as the source and drain.

2. Transistor according to claim 1, characterized in that it also comprises at least one potential well (12) in said first stack in order to increase the carrier concentration in the first stack, said well (12) consisting of at least one semiconductor monolayer of a material having a forbidden energy band below those of the materials of the other layers (14,16) of the first stack.

3. Transistor according to claim 1 or 2, characterized in that the substrate (2), the layers of the first stack (6) and the layers of the second stack (8) are made from III-V material.

4. Transistor according to claim 2, characterized in that the substrate (2) is of GaAs, the layers (14,16) of the first stack (6), other than the potential well (12), are of $In_xGa_{1-x}As$ with $0 \leq x < 1$, the potential well (12) is of $In_{xo}Ga_{1-xo}As$ with $x < xo \leq 1$, the layers (20,22) of the second stack, other than the potential barriers, being of $Al_yGa_{1-y}As$ with $0 < y \leq 1$ and the potential barriers (17,19) are of $Al_{yo}Ga_{1-yo}As$ with $y < yo \leq 1$.

5. Transistor according to claim 4, characterized in that the potential well (12) is of InAs, the layers (20,22) of the second stack, other than the potential barriers, are of $Al_yGa_{1-y}As$ with $0.20 < y < 1$ and the potential barriers (17,19) are of AlAs.

6. Transistor according to claim 2, characterized in that the substrate is of GaAs, the layers (14,16) of the first stack (6), other than the potential well (12), are of $In_xGa_{1-x}As$ with $0 \leq x < 1$, the potential well (12) is of $In_{xo}Ga_{1-xo}As$ with $x < xo \leq 1$, the layers (20,22) of the second stack, other than the potential barriers, are of $In_zGa_{1-z}P$ with $0 < z \leq 0.7$ and the potential barriers (17,19) are of $In_{zo}Ga_{1-zo}P$ with $0 < zo \leq z$.

7. Transistor according to claim 6, characterized in that the potential well is of InAs and the potential barriers of GaP.

8. Transistor according to claim 2, characterized in that the substrate (2) is of InP, the layers (14,16) of the first stack, other than the potential well (12), are of $In_tGa_{1-t}As$ with $0,3 \leq x \leq 1$, the potential well (12) is of $In_{to}Ga_{1-to}As$ with $t < to \leq 1$, the layers (20, 22) of the second stack, other than the potential barriers (18), are of $Al_uIn_{1-u}As$ with $0.3 \leq u \leq 1$ and the potential barriers (17,19) are of $Al_{uo}In_{1-uo}As$ with $u < uo \leq 1$.

9. Transistor according to claim 8, characterized in that the potential well is of InAs and the potential barriers of AlAs.

10. Transistor according to any one of the claims 1 to 9, characterized in that a not intentionally doped, semiconductor buffer layer (4) is provided between the substrate (2) and the first layer stack (6), said buffer layer being of the same nature as the substrate.

11. Transistor according to any one of the claims 1 to 10, characterized in that a highly doped semiconductor material (10) is interposed between the second layer stack (8) and respectively the source and drain (S.G), said material being of the same nature as the substrate (2).

12. Transistor according to any one of the claims 1 to 11, characterized in that it is a TEGFET transistor or a derivative of the latter.

FIG. 1

FIG. 2

FIG. 3

FIG. 4

FIG. 5